# EUROPÄISCHE PATENTANMELDUNG

(11) **EP 2 262 019 A2**
(43) Veröffentlichungstag der Anmeldung: **15.12.2010**
(21) Anmeldenummer: 10164767.5
(22) Anmeldetag: 02.06.2010
(51) Int. Cl.: H01L 35/32

(54) **Thermoelektrische Vorrichtung**

(30) Priorität: 10.06.2009 DE 102009025032
(71) Anmelder: Behr GmbH & Co. KG, 70469 Stuttgart (DE)
(72) Erfinder: Brehm, Holger, 71729, Erdmannhausen (DE); Himmer, Thomas, 73326, Reichenbach (Deggingen) (DE); Heckenberger, Thomas, 70771, Leinfelden-Echterdingen (DE); Riedel, Rudolf, 75173, Pforzheim (DE)

(57) **Zusammenfassung**

Die vorliegende Erfindung betrifft eine thermoelektrische Vorrichtung 1 zur Anordnung zwischen einer Wärmequelle 6 und einer Wärmesenke 7, die eine Mehrzahl thermisch-elektrischer Elemente 3 aufweist, die zwischen einer ersten Fläche und einer zweiten Fläche nebeneinander und beabstandet voneinander angeordnet sind. Die Vorrichtung weist ferner eine eine Mehrzahl von Verbindungselementen 4 auf, die ausgebildet sind, um jeweils zumindest zwei thermoelektrische Elemente über Kontakiflächen elektrisch leitend zu verbinden.

## Beschreibung

Die vorliegende Erfindung bezieht sich auf eine thermoelektrische Vorrichtung zur Anordnung zwischen einer Wärmequelle und einer Wärmesenke und auf eine Vorrichtung zur Wärmeübertragung, die beispielsweise im Fahrzeugbereich eingesetzt werden können.

Die im Abgas in Form von Wärme gespeicherte Energie wird ungenutzt an die Umgebung abgeführt. Um den Wirkungsgrad der Anlage, z.B. eines Fahrzeugs zu erhöhen, und folglich den CO2-Ausstoss im Betrieb zu senken können Maßnahmen zur Nutzung der Abwärme durchgeführt werden.

Solche Ansätze finden sich beispielsweise in den Veröffentlichungen EP1230475B1, EP1475532A2, WO2007026432, JP10281015A, JP2000282960A, JP2004068608A, JP2005083251A und JP2005117836A.

Bekannte Lösungen, die auf thermoelektrischen Materialien basieren, sind wenig effizient, auf Grund des erhöhten Wärmedurchgangswiderstandes zwischen TE-aktiven Materialien und der Wärmequelle bzw. der Wärmesenke.

Es ist die Aufgabe der vorliegenden Erfindung eine verbesserte thermoelektrische Vorrichtung sowie eine verbesserte Vorrichtung zur Wärmeübertragung zu schaffen.

Diese Aufgabe wird durch eine thermoelektrische gemäß Anspruch 1 sowie eine Vorrichtung zur Wärmeübertragung gemäß Anspruch 14 gelöst.

Der vorliegenden Erfindung liegt die Erkenntnis zugrunde, dass der Wirkungsgrad einer Anlage, beispielsweise eines Fahrzeugs erhöht werden kann, und folglich der CO2-Ausstoss im Betrieb gesenkt werden kann, wenn ein thermoelektrischer Generator (TEG) implementiert wird, dessen thermoelektrisches Modul (TEM) einen Teil der Wärme in elektrische Energie umwandelt und diese an die Anlage zurückführt. Der thermoelektrische Generator kann mit unterschiedlichem Nutzen an beliebiger Stelle im Abgasstrang oder in der Abgasrückführung untergebracht sein. Somit ist mittels des erfindungsgemäßen Ansatzes die Erzeugung elektrischer Energie aus Wärmeenergie möglich.

Das thermoelektrische Modul ist mit einem thermoelektrisch aktiven Material bestückt. Wird dieses Material einer Temperaturdifferenz ausgesetzt, erzeugt das thermoelektrische Modul elektrische Energie. Die Temperaturdifferenz entsteht dadurch, dass die beiden gegenüberliegenden Hauptflächen einerseits mit einer Wärmequelle, z.B. Abgas, und andererseits mit einer Wärmesenke, z.B. Kühlmittel, in Kontakt stehen. Der erfindungsgemäße Ansatz ermöglicht einen möglichst geringen Wärmedurchgangswiderstand zwischen den thermoelektrisch-aktiven Materialien und der Wärmequelle bzw. der Wärmesenke.

Beispielsweise können dazu das thermoelektrische Modul oder auch Leiter oder Hüllkörper des thermoelektrischen Moduls mit Rippen versehen werden, um den Wärmeübergang zu verbessern.

Die vorliegende Erfindung schafft eine thermoelektrische Vorrichtung zur Anordnung zwischen einer Wärmequelle und einer Wärmesenke, mit folgenden Merkmalen: einer Mehrzahl thermoelektrischer Elemente, die zwischen einer ersten Fläche und einer zweiten Fläche nebeneinander und beabstandet voneinander angeordnet sind, wobei die thermoelektrischen Elemente jeweils ausgebildet sind, um eine elektrische Spannung zwischen einer ersten Kontaktfläche, die der ersten Fläche zugewandt ist, und einer zweiten Kontaktfläche, die der zweiten Fläche zugewandt ist, zu erzeugen, wenn zwischen der ersten Kontaktfläche und der zweiten Kontaktfläche ein Temperaturunterschied besteht; eine Mehrzahl von ersten Verbindungselementen, die ausgebildet sind, um jeweils zumindest zwei thermoelektrische Elemente über die ersten Kontaktflächen elektrisch leitend zu verbinden; und eine Mehrzahl von zweiten Verbindungselementen, die ausgebildet sind, um jeweils zumindest zwei thermoelektrische Elemente über die zweiten Kontaktflächen elektrisch leitend zu verbinden.

Bei der Wärmequelle kann es sich um einen Abgasstrom oder eine Abgasleitung einer Anlage, beispielsweise eines Fahrzeugs handeln. Bei der Wärmesenke kann es sich beispielsweise um einen Kühlmittelstrom oder um eine Kühlmittelleitung handeln. Die erste Fläche und die zweite Fläche können eine Schnittstelle zwischen der thermoelektrische Vorrichtung und der Wärmesenke beziehungsweise der Wärmequelle darstellen. Dabei können die erste Fläche und die zweite Fläche Teil der thermoelektrischen Vorrichtung und zugleich Teil der Wärmesenke beziehungsweise der Wärmequelle sein. Beispielsweise können die Flächen Abschnitte einer Fluidleitung darstellen. Die thermoelektrische Vorrichtung kann wärmeleitend mit der Wärmequelle und der Wärmesenke verbunden sein. Jedes thermoelektrische Element kann aus einem thermoelektrisch aktiven Material, zum Beispiel einem Halbleiter-Material, bestehen. Die thermoelektrischen Elemente können säulenförmig zwischen der der ersten Fläche und der zweiten Fläche angeordnet sein. Dabei können die thermoelektrischen Elemente beispielsweise in einer Mehrzahl von Reihen und Spalten angeordnet sein. Über die erste Kontaktfläche und die zweite Kontaktfläche können die thermoelektrischen Elemente elektrisch kontaktiert werden. Dies kann mittels der ersten oder zweiten Verbindungselemente erfolgen. Die Verbindungselemente können als Streifen oder Plättchen aus einem elektrisch leitfähigen Material, z.B. Metall, ausgebildet sein. Die elektrische Verbindung der thermoelektrischen Elemente kann in Form einer Serienschaltung oder einer Parallelschaltung erfolgen. Zudem können mehrere einzelne Serienschaltungen wiederum parallel geschaltet werden.

Die thermoelektrische Vorrichtung kann eine über die erste Fläche und/oder die zweite Fläche herausragenden Profilierung aufweisen. Die Profilierung kann beispielsweise so angeordnet sein, dass sie im direkten Kontakt mit einem, Wärme zuführenden Fluid und/oder im direkten Kontakt mit einem, Wärme abführenden Fluid stehen kann. Die Profilierung kann durch eine entsprechende Formgebung der jeweiligen Oberflächen oder durch eine höhenmäßig versetzte Anordnung einzelner Teilelemente der thermoelektrischen Vorrichtung realisiert werden. Mittels der Profilierung können der Wärmeübergang zwischen Wärmequelle und thermoelektrischer Vorrichtung sowie der Wärmeübergang zwischen Wärmesenke und thermoelektrischer Vorrichtung verbessert werden. Beispielsweise kann durch die Profilierung ein Strömungsverhalten eines Fluids gesteuert werden.

Dazu kann beispielsweise zumindest eines der Verbindungselemente eine Profilierung aufweisen. Beispielsweise können alle oder mehrere der ersten Verbindungselemente und/oder der zweiten Verbindungselemente eine entsprechende Profilierung aufweisen. Die ist vorteilhaft, wenn die Verbindungselemente in direktem Kontakt mit der Wärmesenke beziehungsweise der Wärmequelle stehen.

In entsprechender Weise kann zumindest eines der Verbindungselemente mindestens eine Rippe aufweisen, die aus einer, den thermoelektrischen Elementen gegenüberliegenden Oberfläche des Verbindungselements hervorsteht. Eine entsprechende Rippe lässt sich beispielsweise durch eine nach außen zeigende Wölbung oder einen entsprechenden Knick der Verbindungselemente ausformen. Alternativ kann eine entsprechende Rippe durch eine Materialverdickung ausgeformt werden. Durch die Rippe kann eine Wärmeübertragungsfläche vergrößert werden.

Gemäß einer Ausführungsform kann die thermoelektrische Vorrichtung eine erste Hüllschicht aufweisen, die so angeordnet sein kann, dass sich die ersten Verbindungselemente zwischen den thermoelektrischen Elementen und der ersten Hüllschicht befinden. Zusätzlich oder alternativ kann die thermoelektrische Vorrichtung eine zweite Hüllschicht aufweisen, die so angeordnet sein kann, dass sich die zweiten Verbindungselemente zwischen den thermoelektrisch Elementen und der zweiten Hüllschicht befinden. Durch die eine oder die beiden benötigten kann das thermoelektrische Modul ganz oder teilweise umgeben sein. Dadurch können die thermoelektrischen Elemente vor eindringenden Schmutz und vor Feuchtigkeit und gegebenenfalls Flüssigkeiten geschützt werden. Zudem können die Hüllschichten genutzt werden, um eine thermische Anbindung der thermoelektrischen Vorrichtung zu ermöglichten. So können die Hüllschichten in einem direkten Kontakt zu einem wärmezuführenden bzw. wärmeabführenden Fluid stehen. Die Hüllschichten können elektrisch isolieren sein. Die Hüllschichten können aus einem keramischen oder metallischen Werkstoff, aus Kunststoff oder Glas aufgebaut sein.

Die erste Hüllschicht und/oder die zweite Hüllschicht können mindestens eine Rippe aufweisen, die aus einer, den thermoelektrischen Elementen gegenüberliegenden Oberfläche der Hüllschicht hervorsteht. Auf diese Weise kann eine zur Wärmeleitung genutzte Oberfläche der Hüllschichten vergrößert werden.

Ferner kann die thermoelektrische Vorrichtung eine erste Hüllschicht aufweisen, die Aussparungen für die Mehrzahl von ersten Verbindungselementen aufweist und auf Höhe der ersten Verbindungselemente angeordnet sein kann. In entsprechender Weise kann die thermoelektrische Vorrichtung eine zweite Hüllschicht aufweisen, die Aussparungen für die Mehrzahl von zweiten Verbindungselementen aufweist und auf Höhe der zweiten Verbindungselemente angeordnet ist. Auf diese Weise können die Verbindungselemente in die Hüllschichten integriert werden. Äußere Oberflächen der Verbindungselemente können dabei plan mit einer äußeren Oberfläche der Hüllschicht abschließen. Alternativ können die äußeren Oberflächen der Verbindungselemente über die äußere Oberfläche der Füllschicht hinausragende Erhöhungen oder gegenüber der äußeren Oberfläche der Hüllschicht Vertiefungen ausbilden.

Alternativ können die erste Hüllschicht und/oder die zweite Hüllschicht nicht auf Höhe der Verbindungselemente sondern auf Höhe der thermoelektrischen Elemente angeordnet sein. In diesem Fall können die Aussparungen so ausgeformt sein, dass sowohl die Verbindungselemente als auch die thermoelektrischen Elemente zumindest teilweise durch die Aussparungen aufgenommen werden können.

Dabei kann zwischen den thermoelektrischen Elementen eine vordefinierte Substanz angeordnet sein. Die vordefinierte Substanz kann gasförmig, flüssig oder fest sein. Dabei kann die Substanz aus einem thermisch und elektrisch Isolierendem Material bestehen.

Gemäß einer Ausführungsform können benachbarte thermaelektrische Elemente winklig zueinander ausgerichtet sind. Dadurch kann die Wärmeübertragung verbessert werden.

Ferner kann die thermoelektrische Vorrichtung einen ersten elektrischen Kontakt und einen zweiten elektrischen Kontakt zur äußeren Kontaktierung einer Serienschaltung aufweisen, die zumindest einige der thermoelektrischen Elemente umfasst. Mittels der Kontakte kann eine von den thermoelektrischen Elementen erzeugte elektrische Spannung abgegriffen werden.

Gemäß einer Ausführungsform kann die erste Fläche eine Schnittstelle zu einner Wärmequelle und die zweite Fläche eine Schnittstelle zu einer Wärmesenke darstellen. Beispielsweise kann die Wärmequelle eine Abgasleitung und die Wärmesenke eine Kältemittelleitung darstellen.

Die vorliegende Erfindung schafft ferner eine Vorrichtung zur Wärmeübertragung, mit folgenden Merkmalen: einer Einrichtung zum Leiten eines ersten Fluidstroms; einer Einrichtung zum Leiten eines zweiten Fluidstroms; und einer thermoelektrischen Vorrichtung gemäß einem der vorangegangenen Ansprüche, die wärmeleitend zwischen der Einrichtung zum Leiten eines ersten Fluidstroms und der Einrichtung zum Leiten eines zweiten Fluidstroms angeordnet ist. Bei den Einrichtungen zum Leiten kann es sich beispielsweise um eine Abgasleitung und eine Kältemittelleitung handeln.

Bevorzugte Ausführungsbeispiele der vorliegenden Erfindung werden nachfolgend Bezug nehmend auf die beiliegenden Zeichnungen näher erläutert. Es zeigen:
- Fig. 1: eine allgemeine Skizze einer beispielhaften TEM-Ausführung im Quer- schnitt;
- Fig. 2: eine allgemeine Skizze einer beispielhaften TEM-Ausführung isomet- risch;
- Fig. 3: einen Ausschnitt eines Basis-TEM im Querschnitt;
- Fig. 4: einen Ausschnitt eines Basis-TEM, isometrisch;
- Fig. 5: einen Ausschnitt eines TEM mit profilierten Leiter-Rippen im Quer- schnitt;
- Fig. 6: einen Ausschnitt eines TEM mit TEM-Hüllkörper im Querschnitt;
- Fig. 7: einen TEM-Hüllkörper (Deckplatte) mit Aussparungen, isometrisch;
- Fig. 8: einen Ausschnitt eines TEM mit TEM-Hüllkörper mit Aussparungen im Querschnitt;
- Fig. 9: einen Ausschnitt eines TEM mit TEM-Hüllkörper mit Aussparungen im Querschnitt;
- Fig. 10: einen Ausschnitt eines TEM mit TEM-Hüllkörper mit Aussparungen im Querschnitt;
- Fig. 11: einen Ausschnitt eines TEM mit ausgefülltem Zwischenraum im Quer- schnitt;
- Fig. 12: einen Ausschnitt eines TEM mit ausgefülltem Zwischenraum im Quer- schnitt;
- Fig. 13: einen Ausschnitt eines TEM mit nicht-parallelen Materialien, isomet- risch;
- Fig. 14: einen Ausschnitt eines TEM mit nicht-parallelen Materialien, isomet- risch; und
- Fig. 15: einen Ausschnitt eines TEM mit nicht-parallelen Materialien, isomet- risch.

In der nachfolgenden Beschreibung der bevorzugten Ausführungsbeispiele der vorliegenden Erfindung werden für die in den verschiedenen Zeichnungen dargestellten und ähnlich wirkenden Elemente gleiche oder ähnliche Bezugszeichen verwendet, wobei eine wiederholte Beschreibung dieser Elemente weggelassen wird.

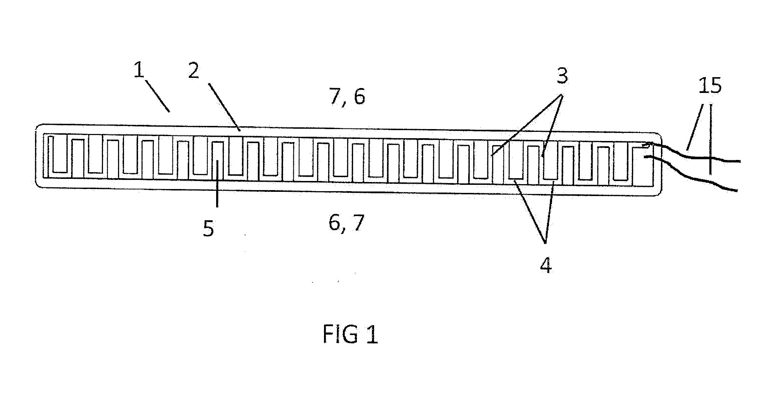

Die Figuren 1 bis 15 zeigen thermoelektrische Vorrichtungen, gemäß unterschiedlichen Ausführungsbeispielen der vorliegenden Erfindung. Dabei können die thermoelektrischen Vorrichtungen ein thermoelektrisches Modul (TEM) 1 darstellen, das einen Hüllkörper 2, thermoelektrisch (TE) aktive Materialien 3, elektrische Leiter 4, Zwischenräume 5, eine Kaltseite (oder alternativ Heißseite) 6, eine Heißseite (oder alternativ Kaltseite) 7, einen hochgestellten Rand 8 am Hüllkörper, eine Längenausrichtung 9, eine Breitenausrichtung 10, profilierte elektrische Leiter 11, einen profilierten Hüllkörper 12, einen Hüllkörper mit Aussparungen 13, einen ausgefüllten Zwischenraum, ein elektrisches Anschlusskabel 15 und nicht-parallele (Anströmwinkel) thermoelektrisch (TE) aktiver Materialien oder Leiter 16 aufweisen kann.

Fig. 1 zeigt eine Darstellung einer thermoelektrischen Vorrichtung, gemäß einem Ausführungsbeispiel der vorliegenden Erfindung. Insbesondere ist eine allgemeine Skizze einer beispielhaften TEM-Ausführung im Querschnitt gezeigt.

Das TEM 1 besteht im Wesentlichen aus thermoelektrisch aktiven Halbleitermaterialien 3, elektrischen Leitern 4 und Anschlusskabeln 15. Optional kann das TEM 1 noch zusätzlich aus einem Hüllkörper 2 und einem Füllkörper bestehen.

An dem TEM 1 liegt auf einer Seite 7 eine Wärmequelle und auf der anderen Seite 6 eine Wärmesenke an, sodass es auf Grund der unterschiedlichen Temperaturen zu einem Wärmetransport von der warmen 7 zur kalten Seite 6 kommt.

Auf diese Weise ist eine Erzeugung elektrischer Energie mit dem TEM 1 möglich. Dabei stellt das thermoelektrische Modul 1 eine Trennebene oder Trennfläche zwischen heißer 7 und kalter 6 Seite dar. Das bedeutet, dass eine Seite 7 des TEM 1 in direktem oder indirektem Kontakt zu einer heißen Quelle 7 steht, und die andere 6 in direktem oder indirektem Kontakt zu einem kalten Bereich 6. Die hierdurch anstehende Temperaturdifferenz zwischen der einen und anderen Seite 7, 6 des TEM 1 ruft Thermodiffusionsströme innerhalb der thermoelektrisch aktiven Materialien 3, z.B. Halbleiter-Materialien, in dem TEM 1 hervor, wodurch eine elektrische Spannung entsteht. Dies kann gemäß dem Seebeck-Effekt erfolgen. Die elektrische Spannung kann in Form von elektrischem Strom abgegriffen werden. Hierzu wird der elektrische Strom über Elektro-Kabet 15, die in das Innere des TEM 1 führen und dort angeschlossen sind einem elektrischen Verbraucher oder einem elektrischen Speicher außerhalb des TEM 1 zugeführt.

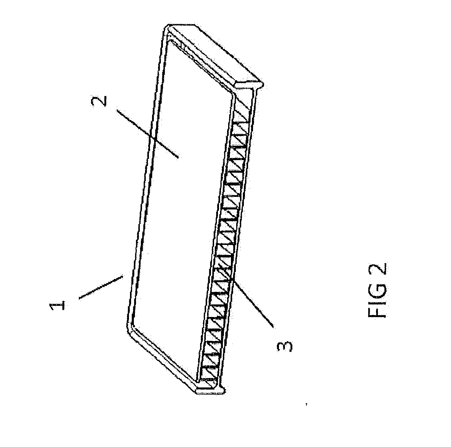

Fig. 2 zeigt eine isometrische Darstellung der in Fig. 1 gezeigten thermoelektrischen Vorrichtung 1, mit dem Hüllkörper 2 und den thermoelektrischen Elementen 3.

In dem TEM 1 werden abwechselnd eine Vielzahl thermoelektrisch aktiver Materialien 3, z.B. n- und p-dotierte Halbleiter, über elektrische Leiter 4 miteinander verschaltet. Die geometrische Ausrichtung der thermoelektrisch aktiven Materialien 3 weist in Richtung dem Wärmestrom von der Warmseite 7 zur Kaltseite 6. Als Werkstoff der TE-aktiven Materialien 3 kann beispielsweise PbTe oder BiTe eingesetzt werden.

Die TE-aktiven Materialen 3 berühren sich gegenseitig nicht, weshalb ein Zwischenraum 5 zwischen den TE-aktiven Materialien 3 besteht. Grundsätzlich sollte aus Effizienzgründen das Verhältnis eines Volumens der TE-aktive Materialien 3 zu einem Volumen der Zwischenräume 5 möglichst groß sein.

Um die gewünschten elektrischen Spannungen und Stromflüsse einzustellen, können die TEM-interneto Halbleiter-Leitermaterialen gleich- oder parallelverschaltet werden. Dies gilt auch für eine mögliche elektrische Verschalung mehrerer TEM 1 untereinander.

Nachfolgend sind verschiedene konstruktive Ausführungen aufgelistet, wobei diese miteinander beliebig kombinierbar sind, sodass es ferner noch zu weiteren Kombi-Ausführungen kommen kann.

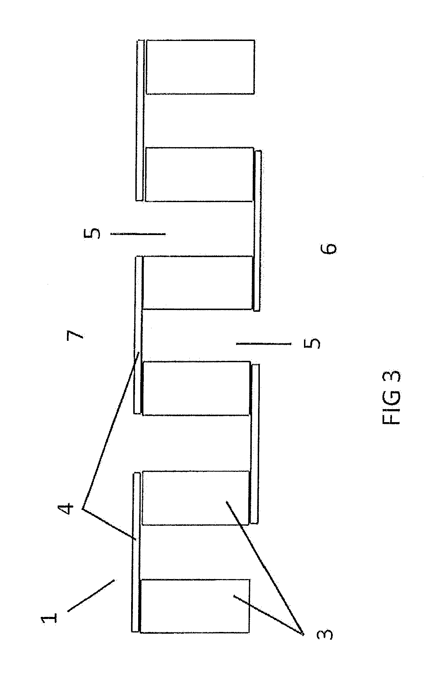

Fig. 3 zeigt eine Darstellung einer thermoelektrischen Vorrichtung, gemäß einem Ausführungsbeispiel der vorliegenden Erfindung. Insbesondere ist einen Ausschnitt eines Basis-TEM im Querschnitt gezeigt.

Das TEM 1 ist ohne weitere Merkmale ausgeführt. Im Zwischenraum 5 der TE-aktiven Materialien 3 befindet sich keine weitere, definierte Substanz. Ein thermoelektrisches Elemente 3 kann zu einem ersten benachbarten thermoelektrischen Element 3 über eine erste Kontaktfläche und zu einem zweiten benachbarten thermoelektrischen Element 3 über eine zweite, der ersten Kontaktflächen gegenüberliegenden Kontaktfläche elektrisch leitend verbunden sein. Auf diese Weise können die thermoelektrischen Elemente 3 in Serie geschaltet sein. Die Leiter 4 können die Kontaktflächen vollständig abdecken. Die thermoelektrischen Elemente 3 können jeweils parallel zueinander ausgerichtet sein.

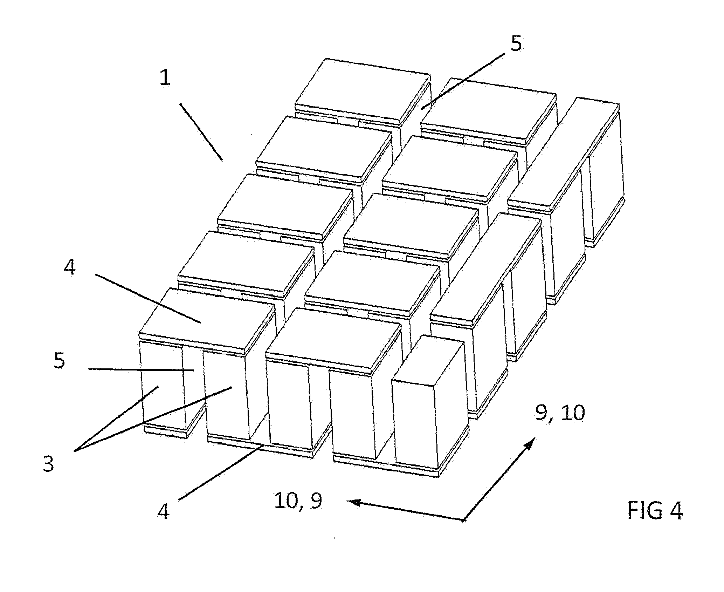

Fig. 4 zeigt eine isometrische Darstellung des in Fig. 3 gezeigten Basis-TEM 1. Dabei können die thermoelektrischen Elemente 3 in einer Mehrzahl von Reihen und Spalten, also matrixförmig angeordnet sein. In einer Reihe angeordnete thermoelektrische Elemente 3 können jeweils in Serie geschaltet sein. Ebenso können die einzelnen Reihen miteinander in Serie geschaltet sein. Die thermoelektrische Elemente 3 können quaderförmig sein und parallel zueinander ausgerichtet sein.

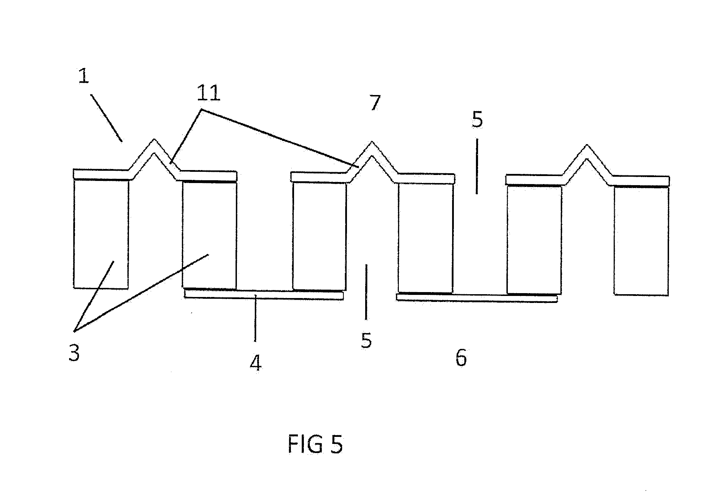

Fig. 5 zeigt eine Darstellung einer thermoelektrischen Vorrichtung, gemäß einem weiteren Ausführungsbeispiel der vorliegenden Erfindung. Insbesondere ist einen Ausschnitt eines TEM 1 mit profilierten Leiter-Rippen, im Querschnitt gezeigt.

Die Leiter 4 sind rippenartig 11 gestaltet, sodass beim Kontakt des TEM 1 mit einem strömenden Fluid der Wärmeübergang verbessert und/oder die Wärmeübertragungsfläche vergrößert wird. Dies führt zu einer Effizienzsteigerung des TEM 1,

Die Leiter 11 können auf der Heißseite 7 oder auf der Kaltseite 6 oder auf beiden Seiten vorgesehen werden.

Die Leiterrippen können dadurch ausgeformt werden, das die Leiter 11 in einem zwischen zwei benachbarten thermoelektrische Elemente 3 liegenden Bereich eine nach außen gerichtete Falte, Wölbung oder Biegung aufweisen. Gemäß diesem Ausführungsbeispiel weisen die Leiterrippen einen spitzen, giebelförmig nach außen gerichteten Verlauf auf.

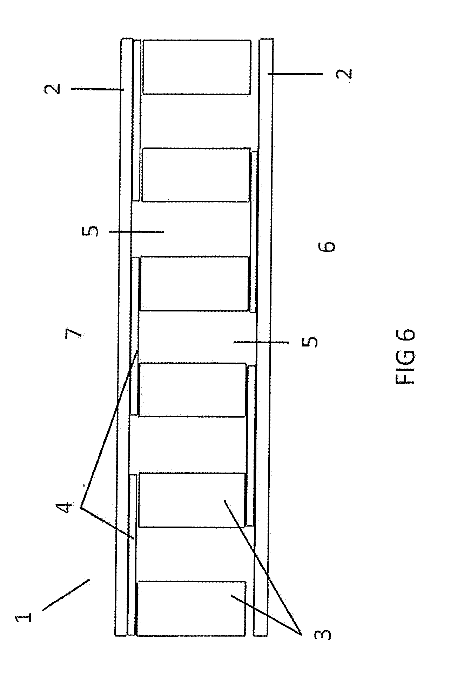

Fig. 6 zeigt eine Darstellung einer thermoelektrischen Vorrichtung, gemäß einem weiteren Ausführungsbeispiel der vorliegenden Erfindung. Insbesondere ist ein Ausschnitt eines TEM 1 mit einem TEM-Hüllkörper 2 im Querschnitt gezeigt.

Die thermoelektrisch aktiven Materialien 3 und die Leitermaterialien 4 können nach außen hin 9, 10 bedeckt werden. Dazu wird das TEM 1 ganz oder teilweise 9, 10 von einer Hüllschicht 2 umgehen. Dieser Hüllkörper 2 ist sodann Teil des TEM 1 und schützt die elektrischen, inneren Komponenten außerdem vor eindringendem Schmutz und vor Feuchtigkeit und ggf. Flüssigkeiten. Außerdem kann der Hüllkörper 2 dazu genutzt werden, das TEM 1 an weitere externe Komponenten, zum Beispiel einen TEG, anzubinden. Außerdem kann der Hüllkörper 2 elektrisch isolierend sein.

Als Hüllkörper-Material 2 kommt beispielsweise ein keramischer oder metallischer Werkstoff oder ein Kunststoff oder ein Glas zum Einsatz. Der Hüllkörper 2 kann ein- oder mehrteilig aufgebaut werden.

Der Hüllkörper 2 kann auf der Heißseite 7 oder auf der Kaltseite 6 oder auf beiden Seiten vorgesehen werden.

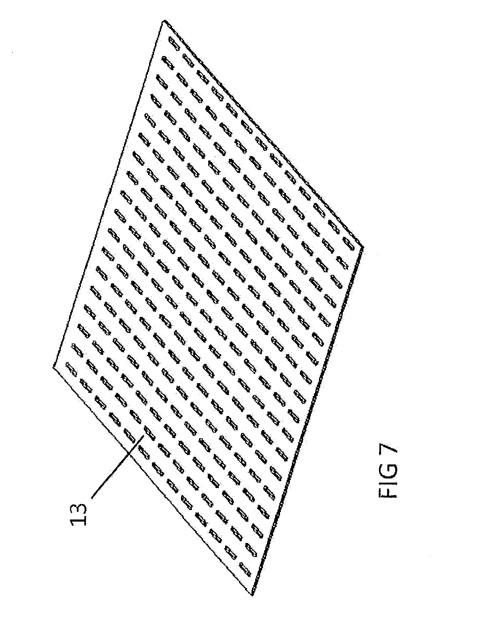

Fig. 7 zeigt eine Darstellung einer Hüllschicht 13 einer thermoelektrischen Vorrichtung, gemäß einem weiteren Ausführungsbeispiel der vorliegenden Erfindung. Insbesondere ist einen TEM-Hüllkörper 13, in Form einer Deckplatte, mit Aussparungen isometrisch gezeigt.

Der Hüllkörper 13 des TEM 1 ist mit Aussparungen versehen, wobei die TE-aktiven Materialien 3 und/oder die Leitermaterialien 4 des TEM 1 diese Aussparungen teilweise oder ganz durchdringen oder gleichgestellt sind. Die Aussparungen entsprechen näherungsweise der Geometrie der TE-aktiven Materialien 3 und/oder der Leitermaterialien 4. Zwischen TE-aktiven Materialien 3 und/oder Leitermaterialien 4 und den Aussparungen im Hüllkörper 13 kann eine Abdichtung eingebracht werden.

Die Aussparungen im Hüllkörper 13 gewährleisten den TE-aktiven Materialien bzw. den Leitermaterialien den direkten Kontakt zur Wärmequelle/ -senke.

Der Hüllkörper 13 kann auf der Heißseite 7 oder auf der Kaltseite 6 oder auf beiden Seiten vorgesehen werden.

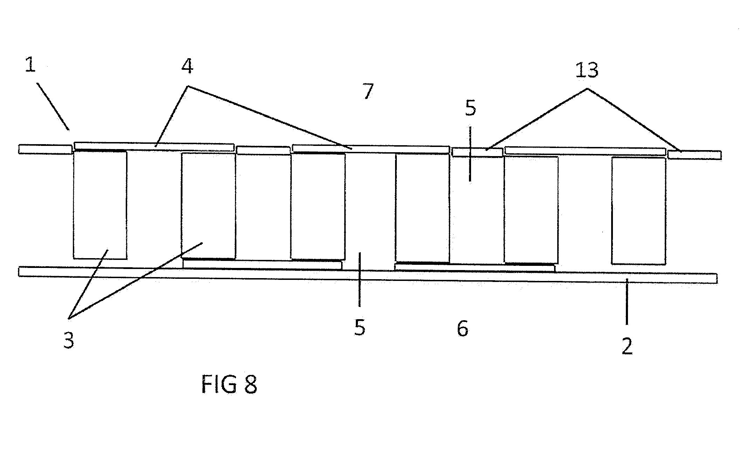

Fig. 8 zeigt eine Darstellung einer thermoelektrischen Vorrichtung, die eine Hüllschicht 13, gemäß dem in Fig. 7 gezeigten Ausführungsbeispiel aufweist. Insbesondere ist einen Ausschnitt eines TEM 1 mit TEM-Hüllkörper 13 mit Aussparungen im Querschnitt gezeigt. Gemäß diesem Ausführungsbeispiel wird auf der Oberseite 7 eine Füllschicht 13 mit Aussparungen und auf der Unterseite 6 eine Hüllschicht 2 ohne Aussparungen eingesetzt. Der TEM-Hüllkörper 13 und die Leiter 4 können eine Ebene bilden. Alternativ können der TEM-Hüllkörper 13 und die Leiter 4 höhenmäßig einen Versatz zueinander aufweisen, so dass eine Profilierung entsteht.

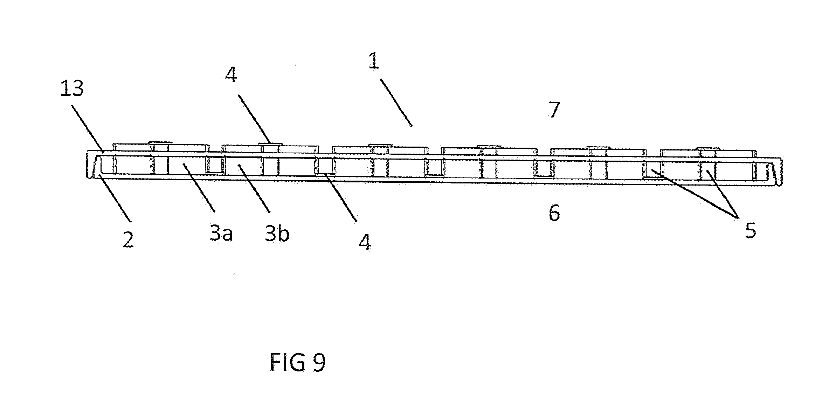

Fig. 9 zeigt eine Darstellung einer thermoelektrischen Vorrichtung, die eine Füllschicht 13, gemäß dem in Fig. 7 gezeigten Ausführungsbeispiel aufweist. Insbesondere ist einen Ausschnitt eines TEM 1 mit TEM-Hüllkörper 13 mit Aussparungen im Querschnitt gezeigt. Gemäß diesem Ausführungsbeispiel ist die Hüllschicht 13 auf Höhe der thermoelektrischen Elemente 3a, 3b angeordnet. Somit erstrecken sich die thermoelektrischen Elemente 3a, 3b zumindest teilweise durch die Aussparungen der Füllschicht 13.

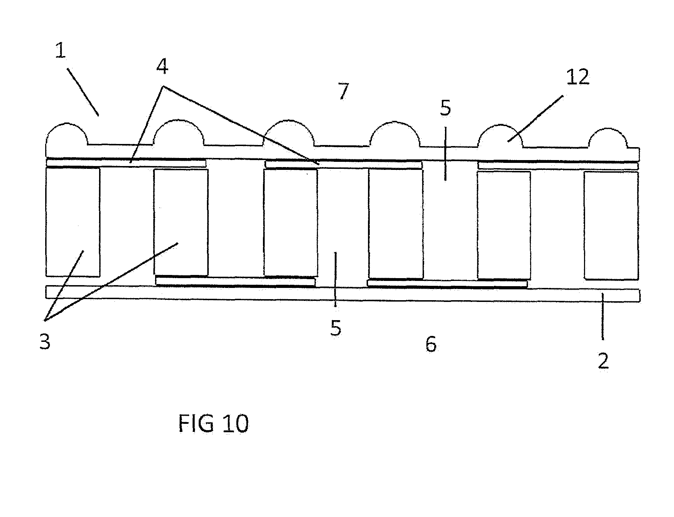

Fig. 10 zeigt eine Darstellung einer thermoelektrischen Vorrichtung, gemäß einem weiteren Ausführungsbeispiel der vorliegenden Erfindung. Insbesondere ist einen Ausschnitt eines TEM 1 mit profiliertem Hüllkörper 12 im Querschnitt gezeigt.

Der Hüllkörper 12 ist rippenartig gestaltet, d.h. profiliert, sodass beim Kontakt des TEM 1 mit einem strömenden Fluid der Wärmeübergang verbessert und/oder die Wärmeübertragungsfläche vergrößert wird, was zu einer Effizienzsteigerung des TEM 1 führt.

Der Hüllkörper 12 kann auf der Heißseite 7 oder auf der Kaltseite 6 oder auf beiden Seiten vorgesehen werden.

Die Rippen können als halbrunde Erhöhungen ausgebildet sein, die über eine Oberfläche der Hüllschicht 12 herausragen. Die Rippen können in, den thermoelektrischen Elementen gegenüberliegenden Bereichen angeordnet sein.

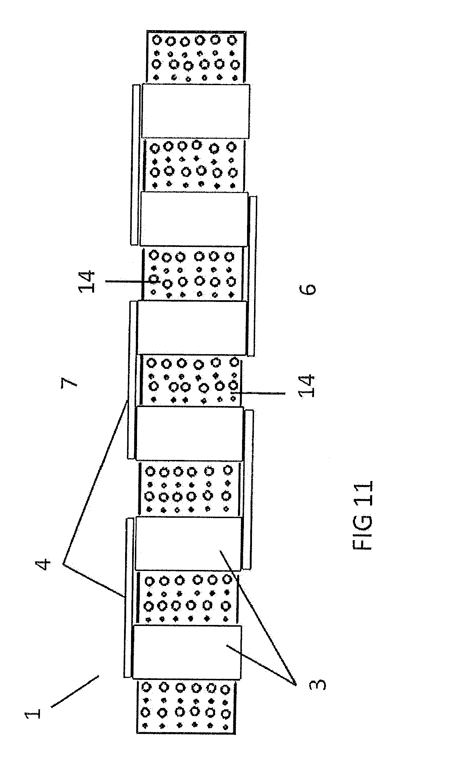

Fig. 11 zeigt eine Darstellung einer thermoelektrischen Vorrichtung, gemäß einem weiteren Ausführungsbeispiel der vorliegenden Erfindung. Insbesondere ist einen Ausschnitt eines TEM 1 mit ausgefülltem Zwischenraum 14 im Querschnitt gezeigt.

Der Zwischenraum ist mit einer definierten Substanz 14 ausgefüllt. Die TE-aktiven Materialien 3 und/oder die Leitermaterialien 4 des TEM 1 können den ausgefüllten Zwischenraum 14 teilweise überragen oder diesem zurück- oder gleichgestellt sein. Die definierte Substanz 14 kann gasförmig, flüssig oder fest sein. Bei tendenziell niedrigeren Temperaturen kann der Zwischenraum 5 mit einem Kunststoff 14 ausgegossen oder ausgeschäumt sein. Auch kann ein vorgeformter Kunststoff 14 den TE-aktiven Materialien 3 formschlüssig übergestülpt werden. Auch kann eine Folie 14 in die Zwischenräume eingebracht werden. Bei tendenziell höheren Temperaturen kann ein keramischer, mineralischer oder glashaltiger Werkstoff vorgesehen werden.

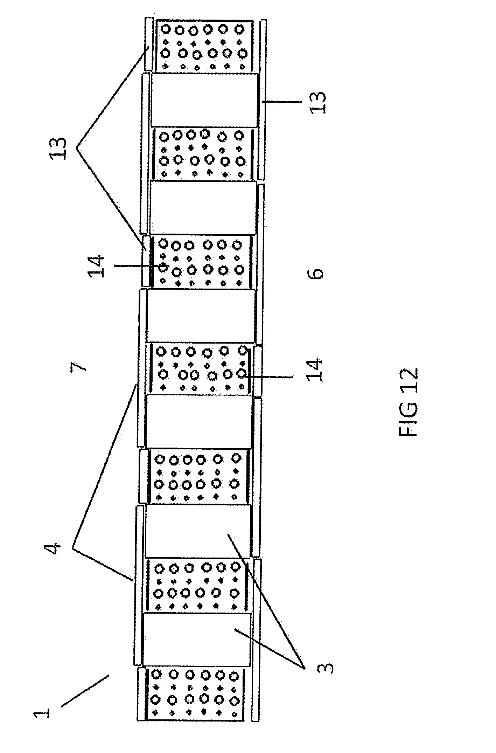

Fig. 12 zeigt eine Darstellung einer thermoelektrischen Vorrichtung, gemäß einem weiteren Ausführungsbeispiel der vorliegenden Erfindung. Insbesondere ist einen Ausschnitt eines TEM 1 mit ausgefülltem Zwischenraum 14 im Querschnitt gezeigt. Dabei handelt es sich um eine Kombination der, anhand der Figuren 11 und 8 beschriebenen Ausführungsbeispielen, d.h. es kann zumindest eine Hüllschicht 13 vorgesehen sein.

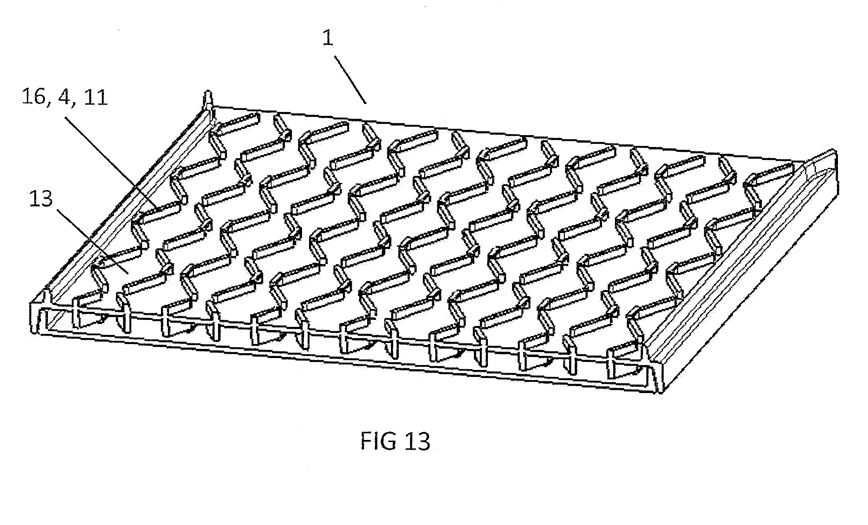

Fig. 13 zeigt eine Darstellung einer thermoelektrischen Vorrichtung, gemäß einem weiteren Ausführungsbeispiel der vorliegenden Erfindung. Insbesondere ist einen Ausschnitt eines TEM mit nicht-parallelen Materialien isometrisch gezeigt.

Entsprechend zu dem, anhand von Fig. 9 beschriebenen Ausführungsbeispiel überragen die TE-aktiven Materialien 3 und/oder die Leiter 4 den Hüllkörper mit Aussparungen 13 und/oder den ausgefüllten Zwischenraum 14. Die TE-aktiven Materialien 16, 3 und/oder die Leiter 16, 4 sind hier in expliziter Weise zueinander schräg gestellt 16. Dies ist insbesondere dann vorteilhaft, wenn es sich bei der Heißseite 7 und/oder der Kaltseite 6 um ein strömendes Fluid handelt, sodass dadurch der Wärmeübergang gesteigert wird. In herkömmlicher Ausführung stehen die TE-aktiven Materialien 3 und/oder die Leiter 4 hauptsächlich parallel zueinander. Die Hüllschicht 13 weist an zwei gegenüberliegenden Randbereichen, die nicht als Eintritts- bzw. Austrittsbereiche für ein Fluid dienen, einen hochgestellten Rand 8 auf. Der hochgestellte Rand 8 kann zumindest an einem Ende eine Biegung nach außen aufweisen.

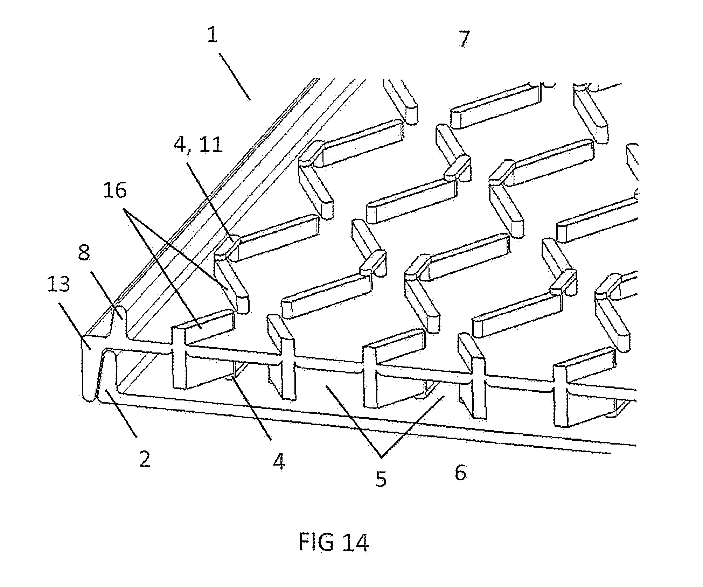

Fig. 14 zeigt eine weitere Darstellung der in Fig. 13 gezeigten thermoelektrischen Vorrichtung. Gemäß diesem Ausführungsbeispiel überlappen sich die Hüllschichten 2, 13 in einem Randbereich. Gemäß diesem Ausführungsbeispiel können die thermoelektrischen Elemente rautenförmig angeordnet sein.

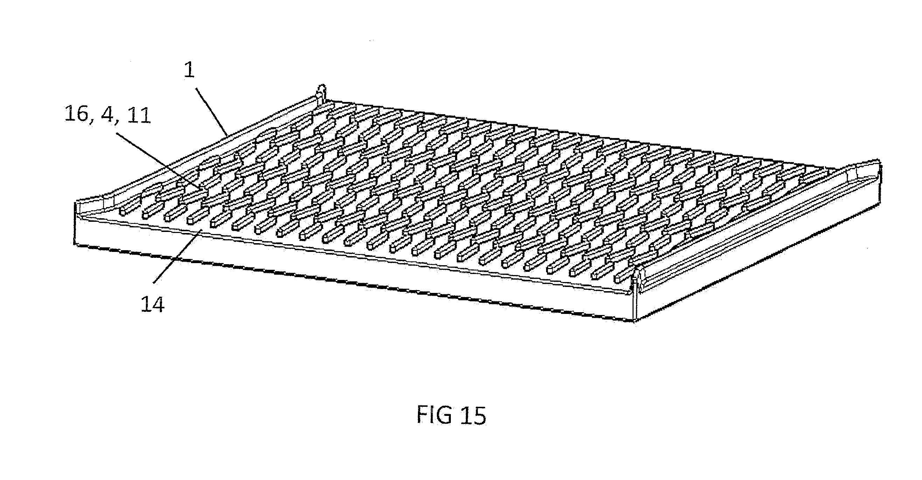

Fig. 15 zeigt eine weitere Darstellung der in Fig. 13 gezeigten thermoelektrischen Vorrichtung.

Die beschriebenen Ausführungsbeispiele sind nur beispielhaft gewählt und können beliebig miteinander kombiniert werden. Umfasst ein Ausführungsbeispiel eine "und/oder" Verknüpfung zwischen einem ersten Merkmal und einem zweites Merkmal, so kann dies so gelesen werden, dass das Ausführungsbeispiel gemäß einer Ausführungsform sowohl das erste Merkmal als auch das zweite Merkmal und gemäß einer weiteren Ausführungsform entweder nur das erste Merkmal oder nur das zweite Merkmal aufweist.

## Patentansprüche

1. Thermoelektrische Vorrichtung (1) zur Anordnung zwischen einer Wärmequelle (6) und einer Wärmesenke (7), mit folgenden Merkmalen:
einer Mehrzahl thermisch-elektrischer Elemente (3), die zwischen einer ersten Fläche und einer zweiten Fläche nebeneinander und beabstandet voneinander angeordnet sind, wobei die thermoelektrischen Elemente jeweils ausgebildet sind, um eine elektrische Spannung zwischen einer ersten Kontaktfläche, die der ersten Fläche zugewandt ist, und einer zweiten Kontaktfläche, die der zweiten Fläche zugewandt ist, zu erzeugen, wenn zwischen der ersten Kontaktfläche und der zweiten Kontaktfläche ein Temperaturunterschied besteht;
eine Mehrzahl von ersten Verbindungselementen (4), die ausgebildet sind, um jeweils zumindest zwei thermoelektrische Elemente über die ersten Kontaktflächen elektrisch leitend zu verbinden; und
eine Mehrzahl von zweiten Verbindungselementen (4), die ausgebildet sind, um jeweils zumindest zwei thermoelektrische Elemente über die zweiten Kontaktflächen elektrisch leitend zu verbinden.

2. Vorrichtung gemäß Anspruch 1, mit einer über die erste Fläche und/oder die zweite Fläche herausragenden Profilierung.

3. Vorrichtung gemäß einem der vorangegangenen Ansprüche, bei der zumindest eines der Verbindungselemente (1) eine Profilierung aufweist.

4. Vorrichtung gemäß einem der vorangegangenen Ansprüche, bei der zumindest eines der Verbindungselemente (11) mindestens eine Rippe aufweist, die aus einer, den thermoelektrischen Elementen (3) gegenüberliegenden Oberfläche des Verbindungselements hervorsteht.

5. Vorrichtung gemäß einem der vorangegangenen Ansprüche, mit einer ersten Hüllschicht (2), die so angeordnet ist, dass sich die ersten Verbindungselemente (4) zwischen den thermoelektrisch Elementen (3) und der ersten Hüllschicht befinden, und/oder einer zweiten Hüllschicht (2), die so angeordnet ist, dass sich die zweiten Verbindungselemente (4) zwischen den thermoelektrisch Elementen und der zweiten Hüllschicht befinden.

6. Vorrichtung gemäß Anspruch 5, bei dem die erste Hüllschicht (12) und/oder die zweite Hüllschicht (12)mindestens eine Rippe aufweisen, die aus einer, den thermoelektrischen Elementen (3) gegenüberliegenden Oberfläche der Hüllschicht hervorsteht.

7. Vorrichtung gemäß einem der Ansprüche 1 bis 4, mit einer ersten Hüllschicht (13), die Aussparungen für die Mehrzahl von ersten Verbindungelementen aufweist und auf Höhe der ersten Verbindungselemente (4) angeordnet ist und/oder mit einer zweiten Hüllschicht (13), die Aussparungen für die Mehrzahl von zweiten Verbindungselementen (4) aufweist und auf Höhe der zweiten Verbindungselemente angeordnet ist

8. Vorrichtung gemäß Anspruch 7, bei der die erste Hüllschicht (13) und/oder die zweite Hüllschicht (13) nicht auf Höhe der Verbindungselemente (4) sondern auf Höhe der thermoelektrischen Elemente (3) angeordnet ist.

9. Vorrichtung gemäß einem der vorangegangenen Ansprüche, bei der zwischen den thermoelektrischen Elementen (3) eine vordefinierte Substanz (14) angeordnet ist.

10. Vorrichtung gemäß einem der vorangegangenen Ansprüche, bei der benachbarte thermoelektrische Elemente (3) winklig zueinander ausgerichtet sind.

11. Vorrichtung gemäß einem der vorangegangenen Ansprüche, mit einem ersten elektrischen Kontakt (15) und einem zweiten elektrischen Kontakt (15) zur äußeren Kontaktierung einer Serienschaltung, die zumindest einige der thermoelektrischen Elemente (3) umfasst.

12. Vorrichtung gemäß einem der vorangegangenen Ansprüche, bei der die erste Fläche eine Schnittstelle zu einer Wärmequelle (6) und die zweite Fläche eine Schnittstelle zu einer Wärmesenke (7) darstellt.

13. Vorrichtung gemäß einem der vorangegangenen Ansprüche, bei der die Wärmequelle (6) eine Abgasleitung und die Wärmesenke (7) eine Kältemittelleitung darstellt.

14. Vorrichtung zur Wärmeübertragung, mit folgenden Merkmalen:
einer Einrichtung (2, 11, 12, 13, 14) zum Leiten eines ersten Fluidstroms (6);
einer Einrichtung (2, 11, 12, 13, 14) zum Leiten eines zweiten Fluidstroms (7); und
einer thermoelektrischen Vorrichtung (1) gemäß einem der vorangegangenen Ansprüche, die wärmeleitend zwischen der Einrichtung zum Leiten eines ersten Fluidstroms und der Einrichtung zum Leiten eines zweiten Fluidstroms angeordnet ist.
